# EUROPEAN PATENT SPECIFICATION

(11) **EP 3 742 467 B1**
(45) Date of publication and mention of the grant of the patent: **02.08.2023**
(21) Application number: 19210644.1
(22) Date of filing: 21.11.2019
(51) Int. Cl.: H01H 69/02, H01H 85/10, H01H 85/041

(54) **A FUSE ASSEMBLY AND METHOD OF MAKING**
SICHERUNGSANORDNUNG UND VERFAHREN ZUR HERSTELLUNG
ENSEMBLE FUSIBLE ET SON PROCÉDÉ DE FABRICATION

(30) Priority: 21.05.2019 US 201916418332
(43) Date of publication of application: 25.11.2020
(73) Proprietor: ROSEMOUNT AEROSPACE INC., Burnsville, MN 55306-4898 (US)
(72) Inventor: POTASEK, David P., Lakeville, MN 55044 (US); PING-TAO FOK, Ben, Rosemount, MN 55068 (US); BACKMAN, Roger Alan, Eagan, MN 55122 (US)
(74) Representative: Dehns

(56) References cited:
- EP-A1- 3 276 831
- EP-A2- 0 228 161
- US-A- 6 166 421
- US-A1- 2004 184 211
- US-B1- 7 486 494

## Description

### BACKGROUND

The embodiments relate to a fuse and more specifically to a thin-film micro-fuse assembly.

Thin film micro-fuses assemblies (fuse assemblies) can be used as state programming switches. In the 'ON' state such assemblies provide a low resistance path for current to flow. When subjected to a high enough current, self-heating occurs such that a fuse element, which is a local area in the fuse assembly, is melted and retreats creating an open or "OFF" state. A prior art thin film fuse is disclosed in EP-A-0228161.

### SUMMARY

Disclosed is a program switch for a circuit with the features of claim 1, in addition with the features of dependent claims 2-7. Further disclosed is a method of forming a program switch for a circuit with the features of claim 8. Further disclosed is a series resistor network with the features of claim 9. Further disclosed is a parallel resistor network with the features of claim 10, in addition with the features of claim 11.

### BRIEF DESCRIPTION OF THE DRAWINGS

The present disclosure is illustrated by way of example and not limited in the accompanying figures in which like reference numerals indicate similar fuse elements.
FIG. 1 illustrates a film micro-fuse assembly (fuse assembly) according to an embodiment;
FIG. 2 illustrates a fuse assembly after a fuse element of the fuse assembly has melted;
FIG. 3 is a method of forming a fuse assembly;
FIG. 4 is a series resistor network having a plurality of the disclosed assemblies; and
FIG. 5 is a parallel resistor network having a plurality of the disclosed assemblies.

### DETAILED DESCRIPTION

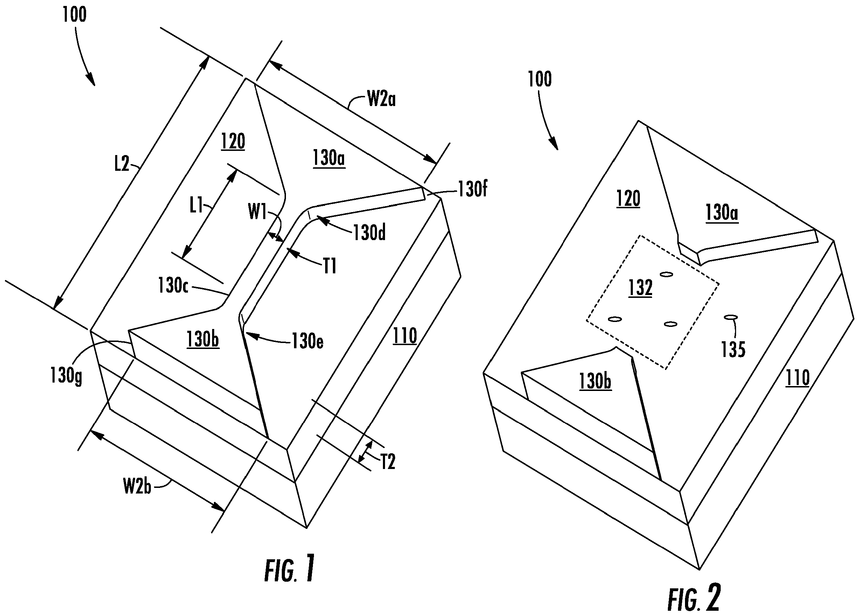

Turning now to FIGS. 1 and 2, disclosed is a thin film micro-fuse assembly ("fuse assembly" or "assembly") 100 in the closed (on) or open (off) states, respectively. Such a fuse assembly 100 may be suitable as a program switch.

The fuse assembly 100 includes a substrate 110. The substrate 110 may be formed of typical semiconductor. The fuse assembly 100 includes an insulating layer 120, which may be a dielectric, disposed on the substrate 110. A conductor generally referred to as 130 is disposed on the insulating layer 120. The conductor 130 may form an inlet terminal 130a, an outlet terminal 130b and a fuse element 130c therebetween. The fuse terminals 130a, 130b may widthwise converge toward the fuse element 130c in a configuration that may be referred to as an hourglass shape. The fuse terminals 130a, 130b may serve as contacts for integrating the fuse assembly 100 in a circuit.

When the fuse assembly 100 is used as a program switch in electrical and electronic circuits, the program state of the fuse assembly 100 is changed by sending relatively high current through the fuse terminals 130a, 130b to melt the fuse element 130c, thereby blowing the fuse assembly 100. This creates a conductive void 132 between the fuse terminals 130a, 130b, thereby providing an open circuit within the fuse assembly 100. The void 132 should be large enough such that electromigration affects cannot 'heal', that is, conduct electricity between the fuse terminals 130a, 130b despite melting of the fuse element 130d. At the same time, design of the fuse assembly 100 should provide for a compact structure with a thin film conductor 130 and a thin film insulating layer 120.

In view of the requirements of the fuse assembly 100, the conductor 130 may be selected that has a low melting temperature and is highly conductive, to thereby enable, melting the fuse element 130c without significantly increasing current. A target melting temperature, for example, may be under seven hundred (700) degrees Celsius. Thus, according to an embodiment, the conductor 130 is aluminum because it is highly conductive and has a melting temperature of less than approximately sixty (660) degrees Celsius.

Further, the insulating layer 120, while thin, should also provide sufficient insulation to prevent, or limit based on specific requirements, heat and electricity from traveling from the conductor 130 to the substrate 110. A target thickness for example may be between 0.14 µm and 1.4 µm and a target thermal insulating value (R) of the insulating layer 120 may be between 0.1e-6 m^2 (°C/W) and 1.0e-6 m^2 (⁰C/W). An insulating value R of a material is a product of its thermal conductivity (Tc) and thickness. Thus, to obtain the target thickness, a suitable material has a Tc of between one (1.0) W/(mK) and ten (10.0) W/(mK). Thus, according to an embodiment, the insulating layer 120 is silicone dioxide because it has a Tc of between 1.3 W/(mK) and 1.5 W/(mK). At a thickness of around 0.4 µm, which is within the target thickness range for the insulating layer 120, silicon dioxide provides an R value of 0.28e-6 m^2 (⁰C/W), which is within the target R value range for the insulating layer 120.

In addition, inherent surface adhesion energy, interfacial tension and wettability characteristics of silicon dioxide enable the aluminum conductor 130 to stick to the insulating layer 120 prior to melting, to form beads 135 upon melting, and remain as beads 135 during subsequent hardening (FIG. 2). The formation of stable beads 135 minimizes a possibility of the fuse assembly 100 healing after being blown, thereby preventing current from passing between the fuse terminals 130a, 130b.

Regarding geometry of the fuse assembly 100, the fuse element 130c has a first thickness T1 and a first width W1 that is between one (1) and five (5) times the first thickness T1. This geometric configuration prevents hot spots from creating an uneven melting of the fuse element 130c and an incomplete separation between the fuse terminals 130a, 130b. In addition, the fuse element 130c transitions to the fuse terminals 130a, 130b, at opposing ends of the fuse element 130d, 130e, with rounded fillets. This transition reduces the occurrence of hot spots at the opposing ends of the fuse element 130d, 130e during the useful life of the fuse assembly 100.

The fuse element 130c has a first length L1 that is between one (1) and three (3) times the first width W1. With this geometric configuration, the void 132 that is obtained upon melting the fuse element 130c provides sufficient separation between the fuse terminals 130a, 130b. In addition, with this geometric configuration, the fuse element 130c is sufficiently short enough to achieve a localized melt of the fuse element 130c while also maintaining a compact size for the fuse assembly 100.

Opposing ends 130f, 130g of the respective fuse terminals 130a, 130b are separated by a second length L2. At the respective opposing ends 130f, 130g, the inlet terminal 130a has a first maximum width W2a and the outlet terminal 130b has a second maximum width W2b. In one embodiment the hourglass shape of the fuse assembly 100 is substantially symmetric so that the fuse terminals 130a, 130b both have the first maximum width W2a. In one embodiment, the second length L2 is about two (2) times the first length L1, and the first maximum width W2a is about ten (10) times the first width W1. This geometric configuration prevents an excess current concentration from building in the fuse terminals 130a, 130b during the useful life of the fuse assembly 100.

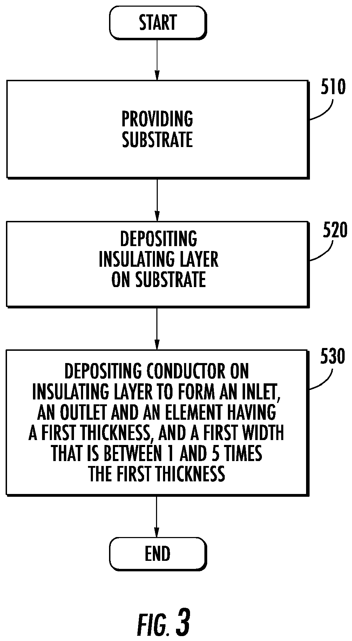

Turning to FIG. 3, a method of forming the fuse assembly 100 is disclosed. The method includes Block 510 providing the substrate 110. The method further includes Block 520 of depositing the insulating layer 120 on the substrate 110. The insulating layer 120, as indicated, comprises silicon dioxide. The method further includes Block 530 depositing the conductor 130 on the insulating layer so that the conductor 130 includes the inlet terminal 130a, the outlet terminal 130b and the fuse element 130c between the inlet terminal 130a and the outlet terminal 130b. As indicated the fuse terminals 130a, 130b widthwise converge toward the fuse element 130c, and the fuse element 130c has a first thickness T1 and a first width W1 that is between one (1) and five (5) times the first thickness T1.

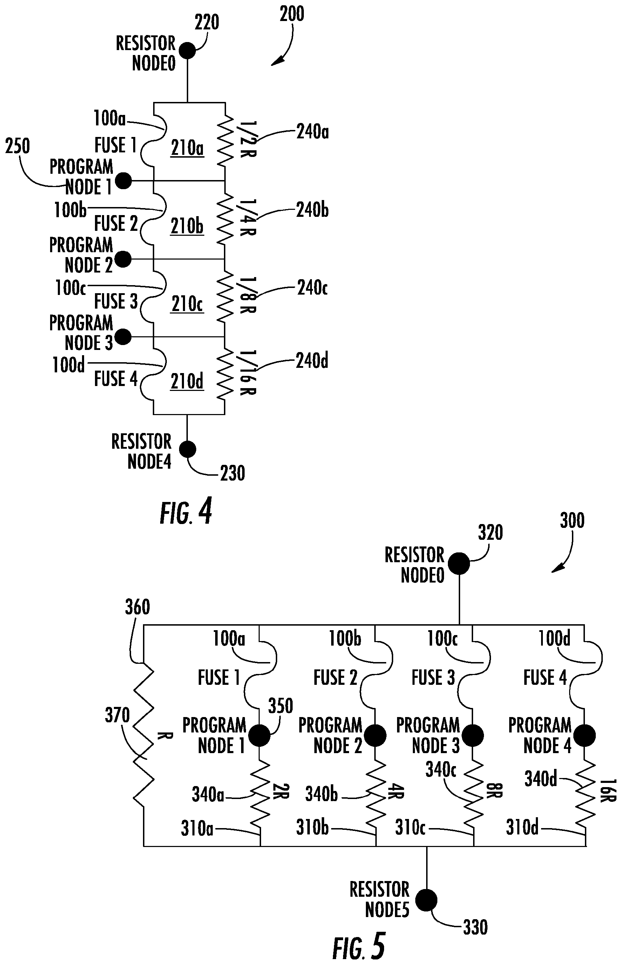

Turning to FIG. 4, further disclosed is a series resistor network (SRN) 200. The SRN 200 includes a plurality of loops generally referred to as 210 arranged in series between a first resistor node 220 and a second resistor node 230. In the SRN 200, each of the plurality of loops 210 includes, in parallel, one of a plurality of resistors generally referred to as 240 and one of a plurality of the fuse assemblies generally referred to as 100, including fuse assemblies 100a-100d. The SRN 200 includes a plurality of program nodes generally referred to as 250 respectively connected between the plurality of loops 210. In the illustrated embodiment there are four loops 210a-210d with a respective four resistors 240a-240d. The four loops 210a-210d are sequentially arranged so that the first loop 210a is proximate the first resistor node 220 and the fourth loop 210d is proximate the second resistor node 230. The resistors 240 in the SRN 200 range in resistivity of between 1/16 R ohms at the first resistor 240a and 1/2 R ohms at the fourth resistor 240d, where each resistor in the sequence doubles the resistance of the next lower resistor in the sequence. As indicated, in the SRN 200, the fuse assemblies 100 function as switches which are controlled by applying or changing current in the respective program nodes 220. Thus, one or more of the program nodes 220 will selectively receive enough current to blow a respective one or more of the fuse assemblies 100, thereby changing, by a predetermined extent, electrical characteristics in the SRN 200.

Turning to FIG. 5, further disclosed is a parallel resistor network (PRN) 300. The PRN 300 includes a plurality of branches generally referred to as 310 arranged in parallel between a first resistor node 320 and a second resistor node 330. In the PRN 300, each of the plurality of branches 310 includes, in series, one of a plurality of resistors generally referred to as 340, one of a plurality of program nodes generally referred to as 350, and one of a plurality of the fuse assemblies generally referred to as 100, including fuse assemblies 100a-100d. In the illustrated embodiment there are four branches 310a-310d with a respective four resistors 340a-340d. The four branches 310a-310d are sequentially arranged, e.g., from left to right. The resistors 340 in the PRN 300 range in resistivity of between 2R and 16R, where 2R is the resistivity of the first resistor 340a and 16R is the resistivity of the fourth resistor 34de, and where each resistor in the sequence doubles the resistance of the next lower resistor in the sequence. The PRN 300 includes another branch 360 arranged in parallel to the plurality of branches 310, which consists of another resistor 370. The other branch 360 prevent the occurrence of open circuit between the first resistor node 320 and the second resistor node 330 if all of the fuse assemblies 100 were to blow. As with the SRN 200, the fuse assemblies 100 in the PRN 300 function as switches which are controlled by applying or changing current in the respective program nodes 350. Thus, as with the SRN 200, one or more of the program nodes 350 will selectively receive enough current to blow a respective one or more of the fuse assemblies 100, thereby changing, by a predetermined extent, electrical characteristics in the PRN 300.

## Claims

1. A program switch for a circuit, the program switch defined by a fuse assembly (100), the fuse assembly comprising:
a substrate (110), wherein the substrate comprises a semiconductor;
an insulating layer (120) disposed on the substrate, the insulating layer comprising silicon dioxide, the thickness of the insulating layer is between 0.14 µm and 1.4 µm;
a conductor (130) disposed on the insulating layer as a top layer of the program switch, the conductor comprising aluminum and having a low melting temperature, and the conductor comprising:
an inlet terminal (130a);
an outlet terminal (130b); and
a fuse element (130c) between the inlet terminal and the outlet terminal, the inlet terminal and the outlet terminal widthwise narrowing toward the fuse element,
**characterised by**
the fuse element having a first thickness and a first width, the first width being between 1 and 5 times the first thickness,
wherein the conductor forms an hourglass shape, defined by:
transitions between the fuse element and the inlet terminal and the outlet terminal including rounded fillets;
opposing ends of the fuse element defining a first length that is between 1 and 3 times the first width; and
a length between opposing ends of the inlet terminal and the outlet terminal being 2 times the first length; and
the inlet terminal and the outlet terminal having a same maximum width that is 10 times the first width,
wherein interfacial tension and wettability characteristics of the silicon dioxide insulating layer enable the aluminum conductor to stick to the insulating layer prior to melting, to form stable beads (135) on the insulating layer (120) upon melting, and remain as stable beads during subsequent hardening, thereby preventing healing of the fuse assembly after being blown and current from passing between the fuse terminals after melting.

2. The program switch of any preceding claim, wherein the conductor has a melting temperature of less than 700 degrees Celsius, or wherein the conductor has a melting temperature of less than 660 degrees Celsius.

3. The program switch of any preceding claim, wherein the insulating layer has an R value between 0.1e-6 m^2 (°C/W) and 1.0e-6 m^2 (°C/W).

4. The program switch of claim 3,
wherein the insulating layer has an R value of at least 0.28e-6 m^2 (°C/W).

5. The program switch of any preceding claim,
wherein the thickness of the insulating layer is at least 0.4 µm.

6. The program switch of any preceding claim, wherein the insulating layer has a thermal conductivity (Tc) of between 1 W/(mK) and 10 W/(mK).

7. The program switch of claim 6
wherein the insulating layer has a Tc of between 1.3 W/(mK) and 1.5 W/(mK).

8. A method of forming program switch for a circuit, the program switch defined by a fuse assembly, the method comprising:
providing a substrate (110), wherein the substrate comprises a semiconductor;
depositing an insulating layer (120) on the substrate, the insulating layer comprising silicon dioxide, the thickness of the insulating layer is between 0.14 µm and 1.4 µm;
depositing a conductor (130) on the insulating layer as a top layer of the program switch, the conductor comprising aluminum and having a low melting temperature, so that the conductor forms:
an inlet terminal;
an outlet terminal; and
a fuse element between the inlet terminal and the outlet terminal, the inlet terminal and the outlet terminal widthwise narrowing toward the fuse element, **characterised by** the fuse element having a first thickness and a first width, the first width being between 1 and 5 times the first thickness,
wherein the conductor forms an hourglass shape, defined by:
transitions between the fuse element and the inlet terminal and the outlet terminal including rounded fillets;
opposing ends of the fuse element defining a first length that is between 1 and 3 times the first width; and
a length between opposing ends of the inlet terminal and the outlet terminal being 2 times the first length; and
the inlet terminal and the outlet terminal having a same maximum width that is 10 times the first width,
wherein interfacial tension and wettability characteristics of the silicon dioxide insulating layer enable the aluminum conductor to stick to the insulating layer prior to melting, to form stable beads (135) on the insulating layer (120) upon melting, and remain as stable beads during subsequent hardening, thereby preventing healing of the fuse assembly after being blown and current from passing between the fuse terminals after melting.

9. A series resistor network comprising:
a plurality of loops (210a-210d) arranged in series between a first resistor node and a second resistor node;
each of the plurality of loops including, in parallel, one of a plurality of resistors and one of a plurality of the program switches of claim 1; and
a plurality of program nodes (220) respectively connected between the plurality of loops.

10. A parallel resistor network comprising:
a plurality of branches (310) arranged in parallel between a first resistor node and a second resistor node; and
each of the plurality of branches including, in series, one of a plurality of resistors, one of a plurality of program nodes, and one of a plurality of the program switches of claim 1.

11. The network of claim 10, including another branch arranged in parallel to the plurality of branches, the other branch consisting of another resistor.

## Patentansprüche

1. Programmschalter für einen Schaltkreis, wobei der Programmschalter durch eine Sicherungsanordnung (100) definiert ist, wobei die Sicherungsanordnung Folgendes umfasst:
ein Substrat (110), wobei das Substrat einen Halbleiter umfasst;
eine auf dem Substrat angeordnete Isolierschicht (120), wobei die Isolierschicht Siliziumdioxid umfasst und die Dicke der Isolierschicht zwischen 0,14 µm und 1,4 µm beträgt;
einen Leiter (130), der auf der Isolierschicht als oberste Schicht des Programmschalters angeordnet ist, wobei der Leiter Aluminium umfasst und eine niedrige Schmelztemperatur aufweist, und wobei der Leiter Folgendes umfasst:
einen Einlassanschluss (130a);
einen Auslassanschluss (130b); und
ein Sicherungselement (130c) zwischen dem Einlassanschluss und dem Auslassanschluss, wobei sich der Einlassanschluss und der Auslassanschluss in der Breite in Richtung des Sicherungselements verjüngen,
**dadurch gekennzeichnet, dass** das Sicherungselement eine erste Dicke und eine erste Breite aufweist, wobei die erste Breite zwischen dem 1- und 5-fachen der ersten Dicke beträgt,
wobei der Leiter eine Sanduhrform bildet, definiert dadurch:
dass Übergänge zwischen dem Sicherungselement und dem Einlassanschluss und dem Auslassanschluss abgerundete Hohlkehlen beinhalten;
dass gegenüberliegende Enden des Sicherungselements eine erste Länge definieren, die zwischen dem 1- und 3-fachen der ersten Breite beträgt; und
dass eine Länge zwischen gegenüberliegenden Enden des Einlassanschlusses und des Auslassanschlusses das 2-fache der ersten Länge beträgt; und
wobei der Einlassanschluss und der Auslassanschluss eine gleiche maximale Breite aufweisen, die das 10-fache der ersten Breite beträgt,
wobei die Grenzflächenspannung und die Benetzbarkeitseigenschaften der Siliziumdioxid-Isolierschicht es dem Aluminiumleiter ermöglichen, vor dem Schmelzen an der Isolierschicht zu haften, beim Schmelzen stabile Perlen (135) auf der Isolierschicht (120) zu bilden und während des anschließenden Aushärtens stabile Perlen zu bleiben, wodurch verhindert wird,
dass die Sicherungsbaugruppe nach dem Durchbrennen wieder ausheilt und nach dem Schmelzen Strom zwischen den Sicherungsanschlüssen fließt.

2. Programmschalter nach einem der vorhergehenden Ansprüche, wobei der Leiter eine Schmelztemperatur von weniger als 700 Grad Celsius aufweist oder wobei der Leiter eine Schmelztemperatur von weniger als 660 Grad Celsius aufweist.

3. Programmschalter nach einem der vorhergehenden Ansprüche, wobei die Isolierschicht einen R-Wert zwischen 0,1e-6 m^2 (°C/W) und 1,0e-6 m^2 (°C/W) aufweist.

4. Programmschalter nach Anspruch 3,
wobei die Isolierschicht einen R-Wert von mindestens 0,28e-6 m^2 (°C/W) aufweist.

5. Programmschalter nach einem der vorhergehenden Ansprüche, wobei die Dicke der Isolierschicht mindestens 0,4 µm beträgt.

6. Programmschalter nach einem der vorhergehenden Ansprüche, wobei die Isolierschicht eine Wärmeleitfähigkeit (Tc) zwischen 1 W/(mK) und 10 W/(mK) aufweist.

7. Programmschalter nach Anspruch 6,
wobei die Isolierschicht eine Tc zwischen 1,3 W/(mK) und 1,5 W/(mK) aufweist.

8. Verfahren zum Bilden eines Programmschalters für einen Schaltkreis, wobei der Programmschalter durch eine Sicherungsanordnung definiert ist, wobei das Verfahren Folgendes umfasst:
Bereitstellen eines Substrats (110), wobei das Substrat einen Halbleiter umfasst;
Abscheiden einer Isolierschicht (120) auf dem Substrat, wobei die Isolierschicht Siliziumdioxid umfasst und die Dicke der Isolierschicht zwischen 0,14 µm und 1,4 µm beträgt;
Abscheiden eines Leiters (130) auf der Isolierschicht als oberste Schicht des Programmschalters, wobei der Leiter Aluminium umfasst und eine niedrige Schmelztemperatur aufweist, sodass der Leiter Folgendes bildet:
einen Einlassanschluss;
einen Auslassanschluss; und
ein Sicherungselement zwischen dem Einlassanschluss und dem Auslassanschluss, wobei sich der Einlassanschluss und der Auslassanschluss in der Breite in Richtung des Sicherungselements verjüngen,
**dadurch gekennzeichnet, dass** das Sicherungselement eine erste Dicke und eine erste Breite aufweist, wobei die erste Breite zwischen dem 1- und 5-fachen der ersten Dicke beträgt,
wobei der Leiter eine Sanduhrform bildet, definiert dadurch:
dass Übergänge zwischen dem Sicherungselement und dem Einlassanschluss und dem Auslassanschluss abgerundete Hohlkehlen beinhalten;
dass gegenüberliegende Enden des Sicherungselements eine erste Länge definieren, die zwischen dem 1- und 3-fachen der ersten Breite beträgt; und
dass eine Länge zwischen gegenüberliegenden Enden des Einlassanschlusses und des Auslassanschlusses das 2-fache der ersten Länge beträgt; und
dass der Einlassanschluss und der Auslassanschluss eine gleiche maximale Breite aufweisen, die das 10-fache der ersten Breite beträgt,
wobei die Grenzflächenspannung und die Benetzbarkeitseigenschaften der Siliziumdioxid-Isolierschicht es dem Aluminiumleiter ermöglichen, vor dem Schmelzen an der Isolierschicht zu haften, beim Schmelzen stabile Perlen (135) auf der Isolierschicht (120) zu bilden und während des anschließenden Aushärtens stabile Perlen zu bleiben, wodurch verhindert wird,
dass die Sicherungsanordnung nach dem Durchbrennen wieder ausheilt und nach dem Schmelzen Strom zwischen den Sicherungsanschlüssen fließt.

9. Vorwiderstandsnetzwerk, umfassend:
eine Vielzahl von Schleifen (210a-210d), die in Reihenschaltung zwischen einem ersten Widerstandsknoten und einem zweiten Widerstandsknoten angeordnet ist;
wobei jede der Vielzahl von Schleifen einen von einer Vielzahl von Widerständen und einen von einer Vielzahl der Programmschalter nach Anspruch 1 in Parallelschaltung beinhaltet; und
eine Vielzahl von Programmknoten (220), die jeweils zwischen der Vielzahl von Schleifen verbunden ist.

10. Parallelwiderstandsnetzwerk, umfassend:
eine Vielzahl von Zweigen (310), die in Parallelschaltung zwischen einem ersten Widerstandsknoten und einem zweiten Widerstandsknoten angeordnet ist; und
wobei jeder der Vielzahl von Zweigen einen von einer Vielzahl von Widerständen, einen von einer Vielzahl von Programmknoten und einen von einer Vielzahl der Programmschalter nach Anspruch 1 in Reihenschaltung beinhaltet.

11. Netzwerk nach Anspruch 10, das einen anderen Zweig beinhaltet, der in Parallelschaltung zu der Vielzahl von Zweigen angeordnet ist, wobei der andere Zweig aus einem anderen Widerstand besteht.

## Revendications

1. Commutateur de programme pour un circuit, le commutateur de programme étant défini par un ensemble fusible (100), l'ensemble fusible comprenant :
un substrat (110), dans lequel le substrat comprend un semi-conducteur ;
une couche isolante (120) disposée sur le substrat, la couche isolante comprenant du dioxyde de silicium, l'épaisseur de la couche isolante est comprise entre 0,14 µm et 1,4 µm ;
un conducteur (130) disposé sur la couche isolante en tant que couche supérieure du commutateur de programme, le conducteur comprenant de l'aluminium et ayant une basse température de fusion, et le conducteur comprenant :
une borne d'entrée (130a) ;
une borne de sortie (130b) ; et
un élément fusible (130c) entre la borne d'entrée et la borne de sortie, la borne d'entrée et la borne de sortie se rétrécissant dans le sens de la largeur vers l'élément fusible,
**caractérisé par**
l'élément fusible ayant une première épaisseur et une première largeur, la première largeur étant comprise entre 1 et 5 fois la première épaisseur,
dans lequel le conducteur forme une forme de sablier, définie par :
des transitions entre l'élément fusible et la borne d'entrée et la borne de sortie comportant des congés arrondis ;
des extrémités opposées de l'élément fusible définissant une première longueur comprise entre 1 et 3 fois la première largeur ; et
une longueur comprise entre des extrémités opposées de la borne d'entrée et de la borne de sortie étant 2 fois la première longueur ; et
la borne d'entrée et la borne de sortie ayant une même largeur maximale égale à 10 fois la première largeur,
dans lequel les caractéristiques de tension interfaciale et de mouillabilité de la couche isolante en dioxyde de silicium permettent au conducteur en aluminium de se coller à la couche isolante avant la fusion, de former des perles stables (135) sur la couche isolante (120) lors de la fusion, et de rester sous forme de perles stables pendant le durcissement ultérieur, empêchant ainsi la réparation de l'ensemble fusible après avoir fondu et le passage du courant entre les bornes du fusible après la fusion.

2. Commutateur de programme selon une quelconque revendication précédente, dans lequel le conducteur a une température de fusion inférieure à 700 degrés Celsius, ou dans lequel le conducteur a une température de fusion inférieure à 660 degrés Celsius.

3. Commutateur de programme selon une quelconque revendication précédente, dans lequel la couche isolante a une valeur R comprise entre 0,1e-6 m^2 (°C/W) et 1,0e-6 m^2 (°C/W).

4. Commutateur de programme selon la revendication 3,
dans lequel la couche isolante a une valeur R d'au moins 0,28e-6 m^2 (°C/W).

5. Commutateur de programme selon une quelconque revendication précédente,
dans lequel l'épaisseur de la couche isolante est d'au moins 0,4 µm.

6. Commutateur de programme selon une quelconque revendication précédente, dans lequel la couche isolante a une conductivité thermique (Tc) comprise entre 1 W/(mK) et 10 W/(mK).

7. Commutateur de programme selon la revendication 6 dans lequel la couche isolante a une Tc comprise entre 1,3 W/(mK) et 1,5 W/(mK).

8. Procédé de formation de commutateur de programme pour un circuit, le commutateur de programme étant défini par un ensemble fusible, le procédé comprenant :
la fourniture d'un substrat (110), dans lequel le substrat comprend un semi-conducteur ;
le dépôt d'une couche isolante (120) sur le substrat, la couche isolante comprenant du dioxyde de silicium, l'épaisseur de la couche isolante est comprise entre 0,14 µm et 1,4 µm ;
le dépôt d'un conducteur (130) sur la couche isolante en tant que couche supérieure du commutateur de programme, le conducteur comprenant de l'aluminium et ayant une basse température de fusion, de sorte que le conducteur forme :
une borne d'entrée ;
une borne de sortie ; et
un élément fusible entre la borne d'entrée et la borne de sortie, la borne d'entrée et la borne de sortie se rétrécissant dans le sens de la largeur vers l'élément fusible,
**caractérisé par** l'élément fusible ayant une première épaisseur et une première largeur, la première largeur étant comprise entre 1 et 5 fois la première épaisseur,
dans lequel le conducteur forme une forme de sablier, définie par :
des transitions entre l'élément fusible et la borne d'entrée et la borne de sortie comportant des congés arrondis ;
des extrémités opposées de l'élément fusible définissant une première longueur comprise entre 1 et 3 fois la première largeur ; et
une longueur comprise entre des extrémités opposées de la borne d'entrée et de la borne de sortie étant 2 fois la première longueur ; et
la borne d'entrée et la borne de sortie ayant une même largeur maximale égale à 10 fois la première largeur,
dans lequel les caractéristiques de tension interfaciale et de mouillabilité de la couche isolante en dioxyde de silicium permettent au conducteur en aluminium de se coller à la couche isolante avant la fusion, de former des perles stables (135) sur la couche isolante (120) lors de la fusion, et de rester sous forme de perles stables pendant le durcissement ultérieur, empêchant ainsi la réparation de l'ensemble fusible après avoir fondu et le passage du courant entre les bornes du fusible après la fusion.

9. Réseau de résistances en série comprenant :
une pluralité de boucles (210a-210d) agencées en série entre un premier noeud de résistance et un second noeud de résistance ;
chacune de la pluralité de boucles comportant, en parallèle, l'une d'une pluralité de résistances et l'un d'une pluralité de commutateurs de programme selon la revendication 1 ; et
une pluralité de noeuds de programme (220) reliés respectivement entre la pluralité de boucles.

10. Réseau de résistances parallèles comprenant :
une pluralité de branches (310) agencées en parallèle entre un premier noeud de résistance et un second noeud de résistance ; et
chacune de la pluralité de branches comportant, en série, l'une d'une pluralité de résistances, l'un d'une pluralité de noeuds de programme et l'un d'une pluralité de commutateurs de programme selon la revendication 1.

11. Réseau selon la revendication 10, comportant une autre branche agencée parallèlement à la pluralité de branches, l'autre branche étant constituée d'une autre résistance.
